# EUROPEAN PATENT APPLICATION

(11) **EP 4 550 385 A1**
(43) Date of publication of application: **07.05.2025**
(21) Application number: 23835314.8
(22) Date of filing: 22.06.2023
(51) Int. Cl.: H01L 21/02, B23K 20/00

(54) **METHOD FOR JOINING SUBSTRATES**

(30) Priority: 06.07.2022 JP 2022108755
(71) Applicant: Meiden Nanoprocess Innovations, Inc., Tokyo 141-0032 (JP)
(72) Inventor: MIURA, Toshinori, Tokyo 141-0032 (JP); KEKURA, Mitsuru, Tokyo 141-0032 (JP)
(74) Representative: Manitz Finsterwald Patent- und Rechtsanwaltspartnerschaft mbB
(86) International application number: PCT/JP2023/023050
(87) International publication number: WO 2024/009780

(57) **Abstract**

In the hydroxyl group formation step (S1), by supplying unsaturated hydrocarbon gas and ozone gas with an ozone concentration exceeding 50 volume% to joining surfaces (1a, 1b) of joining substrates (10) to expose the joining surfaces (10) to OH radicals generated by a radical reaction of both the unsaturated hydrocarbon gas and the ozone gas, hydroxyl groups (molecular layer by hydroxyl groups) are formed via the joining surfaces (10). Then, in a lamination step (S2) the joining substrates are superimposed on the joining surfaces so as to be laminated, and in a joining step, the hydroxyl groups are subjected to a dehydration-condensation reaction by the heating the joining surfaces (1a, 1b) to join the joining substrates (1a, 1b) via the joining surfaces (10).

## Description

### TECHNICAL FIELD

The present invention relates to a method for joining substrates, and relates, for example, to a technology that can contribute to easily join two substrates as desired.

For example, due to the recent increase in the amount of information through electronic devices due to the loT, there has been a demand for further sophistication of semiconductor devices. Although the development of technology for miniaturization and integration of semiconductor devices (Moore's Law) has been promoted in the past, further technological progress (More Than Moore) is demanded, and as one example of this, the development and practical application of three-dimensional laminates (3D-IC) can be cited.

For example, in the case of a three-dimensional laminate in which a plurality of substrates (substrates to be joined such as semiconductor substrates) having different design rules, functions and the like are laminated and joined, not only can the degree of integration of semiconductor devices be increased, but the functions of respective substrates (different functions) can also be integrated. In addition, it can contribute to reducing wiring distance, and thus various features (new advantages and the like) can be obtained.

In the joining of substrates to be joined in three-dimensional laminates, a joining method in which adhesives and the like are not used, namely, a direct joining method is applied, and in recent years, a mode in which electrodes and the like provided on the joining surfaces of the joining substrates can be simultaneously joined (hybrid joining) has begun to attract attention. As a specific example of the direct joining method, so-called fusion joining and surface-activated joining methods can be cited, and among them, the fusion joining has been widely adopted in the field of three-dimensional laminates.

The fusion joining method mainly has (1) a step for forming hydroxyl groups on surfaces to be joined (joining surface which has been flattened in advance as needed) of substrates to be joined (hereinafter simply referred to as a hydroxyl group formation step), (2) a step for superimposing and laminating the two joining substrates formed with hydroxyl groups on the joining surfaces (hereinafter simply referred to as a lamination step), and (3) a step for joining the joining substrates to each other on the joining surfaces by causing a dehydration-condensation reaction of hydroxyl groups in the laminated state (hereinafter simply referred to as a joining step).

In addition to the direct joining method mentioned above, other technologies related to the substrate itself include a surface treatment method for modifying the surface of the substrate (for example, patent documents 1-4), a film deposition method for forming various thin films on the surface of the substrate using the CVD (chemical vapor deposition) or ALD (atomic layer deposition) method (for example, patent documents 5 and 6), and the like.

### BACKGROUND TECHNOLOGY

### PRIOR ART REFERENCE(S)

### PATENT DOCUMENT(S)

Patent Document 1: Japanese Patent No. 4905253
Patent Document 2: Japanese Patent No. 5217951
Patent Document 3: Japanese Patent No. 6052470
Patent Document 4: Japanese Patent No. 6057030
Patent Document 5: Japanese Patent No. 6569831
Patent Document 6: Japanese Patent No. 7056710

### SUMMARY OF THE INVENTION

In the hydroxyl group formation step of a general direct joining method, hydroxyl groups are formed on the surfaces to be joined of substrates to be joined by treatment using water as a raw material (for example, aqueous solution treatment and steam plasma treatment), and it may cause moisture to remain on the joining surfaces.

In this case, in the joining step, the dehydration-condensation reaction may be suppressed by the remaining moisture as mentioned above, and it may be difficult to join the joining substrates to each other.

In addition, if the steam plasma treatment is applied to form hydroxyl groups in the hydroxyl group formation step, the plasma may damage the joining surfaces, and the surface roughness of the joining surfaces increases. In this case, the lamination or/and joining step cannot be performed as desired, and it may be difficult to join the joining substrates to each other.

The present invention is made in consideration of such a technical problem, and an object of the present invention is to provide a technology which can contribute to the suppression of moisture from remaining on the joining surface of each of the joining substrates so as to join each of the substrates easier as desired.

In one aspect of a substrate joining method in the present invention, the method includes: a hydroxyl group formation step for forming hydroxyl groups on surfaces to be joined of respective two substrates to be joined which are housed in a chamber; a lamination step for superimposing the joining substrates formed with the hydroxyl groups via the joining surfaces of the respective joining substrates so as to be laminated; and a joining step for joining the joining substrates via the joining surfaces of the respective joining substrates by heating each of the laminated joining substrates.

Then, in the hydroxyl group formation step, the hydroxyl groups are formed on the joining surfaces by supplying unsaturated hydrocarbon gas and ozone gas with an ozone concentration exceeding 50 volume% to the joining surfaces of the joining substrates housed in the chamber to expose the joining surfaces to OH radicals generated by a radical reaction of both the unsaturated hydrocarbon gas and the ozone gas, and in the joining step, the hydroxyl groups are subjected to a dehydration-condensation reaction by the heating.

In addition, the chamber is provided with an unsaturated hydrocarbon gas supply part which supplies the unsaturated hydrocarbon gas into the chamber, an ozone gas supply part which supplies the ozone gas into the chamber, and a gas discharge part which sucks gas from the chamber and discharges it to an outside of the chamber, and the hydroxyl group formation step is performed in a state in which pressure inside the chamber is reduced.

In addition, a water contact angle of the joining surfaces of the joining substrates is set within a range of 4° to 10° by the hydroxyl group formation step.

In addition, the hydroxyl group formation step is performed to control an amount of the hydroxyl groups on the joining surfaces of the joining substrates by adjusting a supply flow rate ratio of both the unsaturated hydrocarbon gas and the ozone gas supplied into the chamber.

In addition, the hydroxyl group formation step is performed to control an amount of the hydroxyl groups on the joining surfaces of the joining substrates by adjusting a supply flow rate and supply time of both the unsaturated hydrocarbon gas and the ozone gas such that a supply flow rate ratio of both the unsaturated hydrocarbon gas and the ozone gas supplied into the chamber is constant.

In addition, metal wirings made of one of copper, gold, tungsten and aluminum are provided on the respective joining surfaces of the joining substrates, and the metal wirings provided on the respective joining substrates are joined to each other in the joining step.

In addition, the chamber is provided with a support part which supports each of the joining substrates in the inside of the chamber, and the support part supports each of the joining substrates such that the joining surfaces of the respective joining substrates move freely in contact with or apart from each other in a facing direction in a posture in which the joining surfaces of the respective joining substrates face each other.

Each of the joining surfaces of the joining substrates is a surface of a silicon oxide film which is provided on one end side surface of each of the joining substrates in advance in an oxide film formation step, which is a step before the hydroxyl group formation step.

In addition, the chamber is further provided with a raw material gas supply part which supplies a raw material gas containing Si, which is an element that forms the silicon oxide film, as a constituent element, into the chamber, and the oxide film formation step is performed to form the silicon oxide film by supplying the unsaturated hydrocarbon gas, the ozone gas and the raw material gas to the one end side surface of each of the joining substrates housed in the chamber, by a chemical vapor deposition or atomic layer deposition method using a radical reaction of both the unsaturated hydrocarbon gas and the ozone gas.

The unsaturated hydrocarbon gas is one of propylene, acetylene, butadiene, benzene, toluene, o-xylene, styrene, α-butylene, 1,3-butadiene, 1,2-butadiene, 3-methyl-1,2-butadiene, 2-methyl-1,3-butadiene, 1,3-pentadiene and 2,3-dimethyl-1,3-butadiene.

Each of the joining substrates is a same or different type substrate selected from a group consisting of a silicon substrate, a glass substrate, a GaN substrate, a SiC substrate, a diamond substrate, a substrate formed with a silicon oxide film on one end side surface of each of the joining substrates, a metal substrate, and a film substrate.

The raw material gas comprises one or more kinds selected from an organic gas source group consisting of TEOS, HMDS-O and HMDS-N.

As the above, according to the present invention, it is possible to contribute to suppressing moisture from remaining on the joining surfaces of the joining substrates and facilitating the joining of each of the joining substrates as desired.

### BRIEF DESCRIPTION OF THE DRAWINGS

FIG. 1 is a characteristic diagram of the concentration of ozone gas and OH radical generation efficiency (drawing in which the ashing rate is normalized to 1 when the ozone concentration is approximately 100 volume% as an index of the effectiveness of the photoresist ashing on an Si wafer).
FIG. 2 is a process chart (schematic diagram) for explaining a joining method for substrates by Example 1.
FIG. 3 is a schematic diagram for explaining the radical reaction in a hydroxyl group formation step S1.
FIG. 4 is a schematic block diagram for explaining a chamber 2A which is the chamber 2A).
FIG. 5 is a schematic block diagram for explaining a chamber 2B which is applicable to the joining method for the substrates by Example 1 (view through the chamber 2B).
FIG. 6 is a schematic block diagram for explaining a chamber 2C which is applicable to the joining method for the substrates by Example 5 (view through the chamber 2C).

### MODE FOR IMPLEMENTING THE INVENTION

A method for joining substrates in an embodiment of the present invention is completely different from the common direct joining method, which uses water as a raw material in a hydroxyl group formation step (such as aqueous solution treatment or steam plasma treatment) to form hydroxyl groups (hereinafter simply referred to as a conventional method as appropriate).

That is, in a method for joining substrates in the present embodiment, in a hydroxyl group formation step, unsaturated hydrocarbon gas and ozone gas with ozone concentration exceeding 50 volume% are supplied to surfaces to be joined of substrates to be joined to expose the joining surfaces to OH radicals generated by the radical reaction of both the unsaturated hydrocarbon gas and the ozone gas to form hydroxyl groups (molecular layer by hydroxyl groups) on the joining surfaces.

Then, in a lamination step, the joining substrates are superimposed on the joining surfaces so as to be in a lamination state, and in a joining step, the joining substrates are heated to induce a dehydration-condensation reaction of the hydroxyl groups, thereby joining the joining substrates via the joining surfaces.

According to the present embodiment, moisture can be suppressed from remaining on the joining surfaces of the joining substrates in the hydroxyl group formation step. Consequently, the dehydration-condensation reaction of the hydroxyl groups occurs easier in the joining step. In addition, because steam plasma treatment and the like, as in the conventional method, are not required (because the plasma does not damage the joining surfaces of the joining substrate), the surface roughness of the joining surfaces can be maintained in a sufficiently small state (for example, atomically small), and the lamination step and the joining step can be performed easier as desired. With this, the joining substrates can be joined to each other on the joining surfaces easier as desired.

The method for joining the substrates in the present embodiment is sufficient if hydroxyl groups can be formed on the joining surfaces by exposing the joining surfaces of the joining substrates to OH radicals generated by the radical reaction of both the unsaturated hydrocarbon gas and the ozone gas in the hydroxyl group formation step, as mentioned above. That is, technical knowledge from various fields (for example, direct joining, chambers, ozone gas, unsaturated hydrocarbon gas, radical reaction, surface treatment fields, film deposition by CVD, ALD and the like) is appropriately applied and design change can be performed by referring to prior art documents as necessary, and one example thereof, Examples 1 to 5 described below can be cited. In addition, in Examples 1 to 5 below, detailed explanations are omitted as appropriate, for example, by applying the same symbols to duplicate content.

### <<Reference example for radical reaction>>

For example, the patent documents 1 and 2 disclose a technology for removing resist which adheres to the surfaces of objects to be surface-treated by using active species (oxidizing species) such as OH radicals generated by the radical reaction between unsaturated hydrocarbon gas and ozone gas. This resist removal technology is one performed using the properties of ozone. For example, it is one utilizing that the ozone easily reacts with the double bonds of the carbons of unsaturated hydrocarbons, even without thermal energy (heating) or UV irradiation.

The resist removal technology using the radical reaction mentioned above has a high effect of removing organic matters such as photoresist, and has been put into practical use, for example, for ashing photoresist and removing organic matters on a surface without thermal damage or plasma damage.

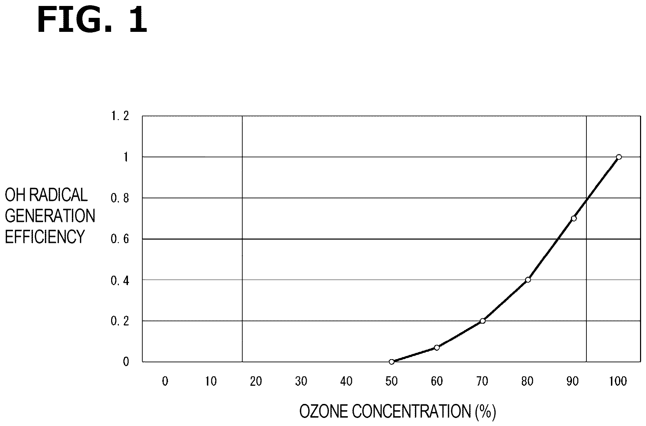

In the radical reaction, carbon double bonds are initially cleaved by ozone molecules, and unstable methylene peroxide generated due to the cleaving, as an intermediate, undergoes a separation reaction, then OH radicals, formic acid, and the like are generated together with carbon dioxide and water. An example of this radical reaction can be shown by a characteristic diagram of ozone gas concentration and the efficiency of OH radical generation, as shown in FIG. 1.

In FIG. 1, since when the concentration of ozone gas is low (for example, 50 volume% or lower), the efficiency of OH radical generation is also low, the OH radicals and the like are easily consumed in an intermediate reaction. That is, it can be read that a multi-stage reaction process where the generation of OH radicals is amplified is few, and it becomes difficult to perform a desired surface treatment. On the other hand, when the concentration of ozone gas is high, OH radicals are generated at high concentrations, and furthermore, large amounts of OH radicals are easily generated in the multi-stage reaction process.

In addition, although, in conventional ozone gas generation devices (for example, general discharge ozonizers), the concentration of the ozone gas that can be supplied is low (for example, maximum ozone concentration of approximately 23 volume%), in recent years, by the appearance of devices capable of safely generating ozone gas at high concentrations (for example, a pure ozone generator manufactured by MEIDENSHA CORPORATION), various surface treatment technologies applying radical reactions have begun to be investigated.

For example, in the patent documents 3 and 4, technology is disclosed in which the surface of a surface treatment object (object to be modified) is oxidized using OH radicals and hydrophilic groups, mainly hydroxyl groups (molecular layer with hydrophilic groups), are further formed, to modify the surface. This modification technology is capable of modifying the surface of the object to be modified without causing physical damage and the like to the modification object.

Specifically, in the patent documents 3 and 4, a method is disclosed in which unsaturated hydrocarbon gas and ozone gas are supplied into a chamber containing an object to be modified to cause a radical reaction near the surface of the modification object, and the surface of the modification object is modified by OH radicals and the like generated in the radical reaction. In addition, a configuration is also disclosed in which unsaturated hydrocarbon gas and ozone gas are supplied into the chamber via a showerhead integrating an unsaturated hydrocarbon gas supply part and an ozone gas supply part (numeral 9 in the patent document 3, numeral 10 or 15 in the patent document 4).

By applying the radical reaction mentioned above to the hydroxyl group formation step of the direct joining method, it is possible to form a sufficient amount of hydroxyl groups on the joining surfaces of the joining substrates without, for example, performing treatment using water as a raw material as in conventional methods. In addition, it is also possible to suppress moisture from remaining on the joining surfaces of the joining substrates.

According to the hydroxyl group formation step to which the redial reaction is applied, although energy from such the radical reaction (chemical reaction energy) acts on the joining surfaces of the joining substrates, the acting of energy from plasma treatment and the like (energy that can cause plasma damage) as in conventional methods can be avoided. Consequently, the surface roughness of the joining surfaces can be maintained sufficiently small.

For example, in the case where a plurality of joining substrates such as glass substrates are joined by a direct joining method to form an optical lens, it is desirable to perform the lamination and joining steps in a state in which the joining surfaces of the respective joining substrates are maintained at a sufficiently small surface roughness at an atomic level (good flatness). Here, according to the hydroxyl group formation step applying the radical reaction mentioned above, it is possible to maintain a sufficiently small surface roughness at an atomic level (good flatness) on the joining surfaces of the respective joining substrates after the hydroxyl group formation step and to obtain a desired optical lens by performing the lamination and joining steps as appropriate.

### <<Example 1>>

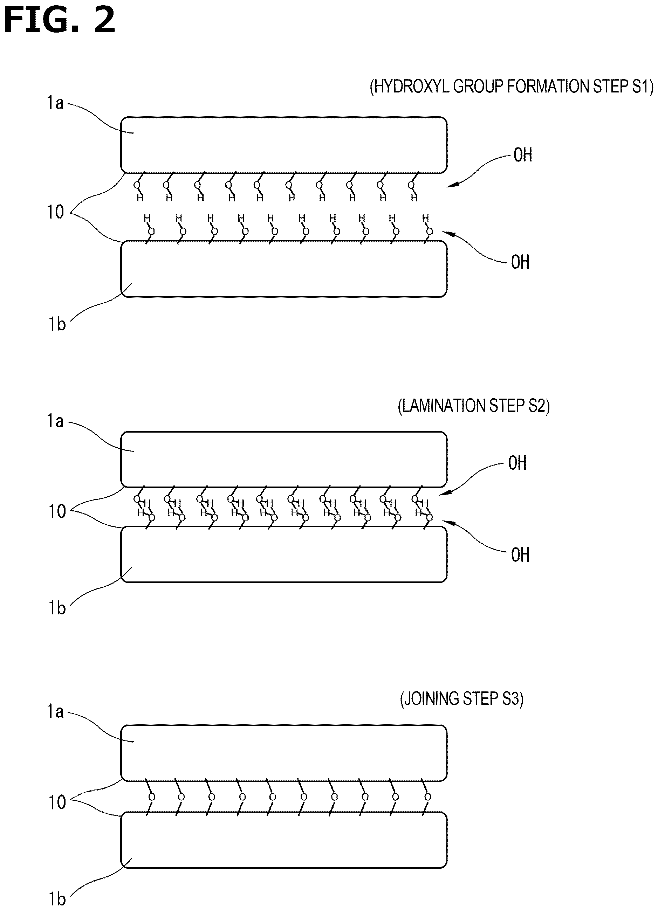

The joining method of Example 1 is to join a plurality of substrates 1 to be joined (two flat substrates to be joined 1a and 1b in FIG. 2; hereinafter collectively referred to as simply substrates 1) on surfaces 10 to be joined by performing a hydroxyl group formation step S1, lamination step S2, and joining step S3 in this order as shown in FIG. 2, and is performed using a radical reaction as shown in the above reference example in the hydroxyl group formation step S1.

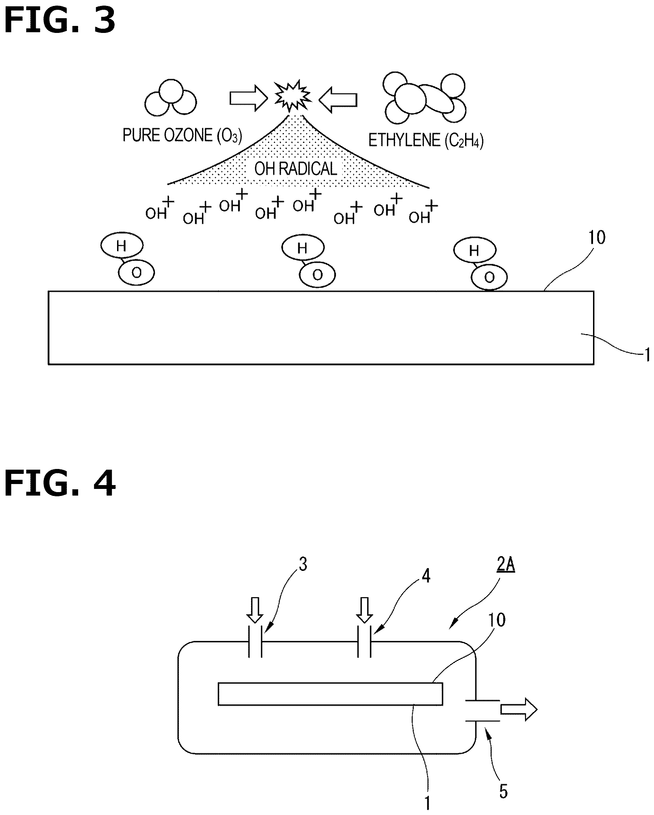

In the hydroxyl group formation step S1 shown in FIG. 2, unsaturated hydrocarbon gas and ozone gas with an ozone concentration exceeding 50 volume% are supplied to the joining surfaces 10 of the joining substrates 1. Consequently, as shown, for example, in FIG. 3, for example, a radical reaction occurs near the joining surfaces 10 of the joining substrates 1 by both the unsaturated hydrocarbon gas (ethylene in FIG. 3) and the ozone gas (pure ozone in FIG. 3), and the joining surfaces 10 of the joining substrates 1 are exposed to OH radicals (OH⁺) generated by the radical reaction, then hydroxyl groups (molecular layer of hydroxyl groups indicated by the symbol of OH in the drawing) are formed on the joining surfaces 10.

Next, in the lamination step S2, two joining substrates 1a and 1b, which have been formed with the hydroxyl groups in the hydroxyl group formation step S1, are superimposed so as to be laminated (temporary lamination) via joining surfaces 10 of the respective joining substrates 1a and 1b. The joining substrates 1a and 1b in the laminated state are brought into pressure-contact with each other (for example, at 1 MPa or higher) such that the joining surfaces 10 of the respective joining substrates 1a and 1b come in sufficiently contact with each other.

Then, in the joining step S3, by heating each of the joining substrates 1a and 1b, which have been laminated in the lamination step S2 mentioned above, the hydroxyl groups are subjected to a dehydration-condensation reaction. As a result, the joining substrates 1a are 1b are joined on the joining surfaces 10.

### <One example of chamber applicable in hydroxyl group formation step S1>

In the hydroxyl group formation step S1, for example, a joining substrate 1 is housed in a chamber and the chamber is depressurized, and by supplying unsaturated hydrocarbon gas and ozone gas into the chamber, hydroxyl groups are formed on a joining surface 10 of the joining substrate 1. The chamber can be used in various forms, as long as it can supply unsaturated hydrocarbon gas and ozone gas while housing the joining substrate 1 as mentioned above, and can form hydroxyl groups on the joining surface 10.

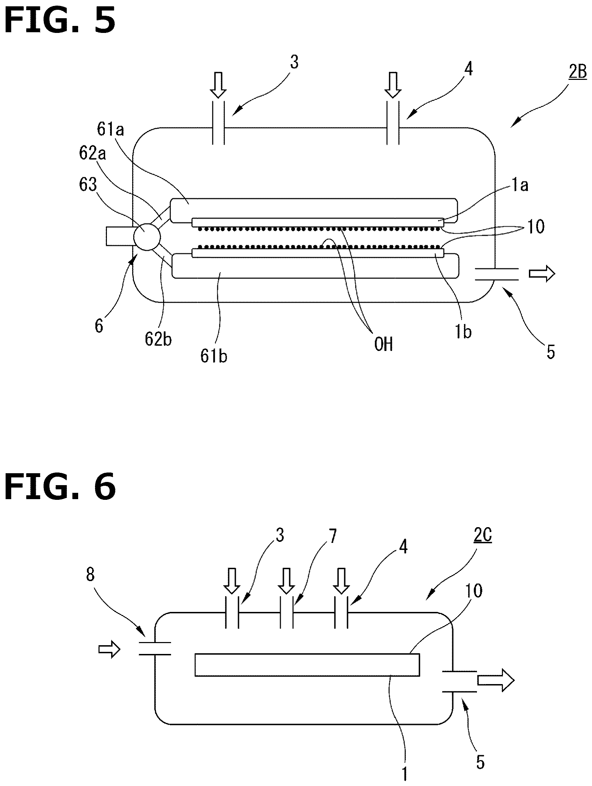

As one example thereof, a chamber 2 shown in FIG. 4 (chamber 2A in FIG. 4, chambers 2B in FIG. 5 and 2C in FIG. 6 below; hereinafter collectively referred to as chamber 2 simply) is provided with an unsaturated hydrocarbon gas supply part 3 for supplying unsaturated hydrocarbon gas into the chamber 2, an ozone gas supply part 4 for supplying ozone gas into the chamber 2, and a gas discharge part 5 which sucks the gas in the chamber 2 and discharges it to the outside of the chamber 2. In the gas discharge part 5, a mode can be cited which is not only possible to sucks the gas in the chamber 2 and discharge it to the outside of the chamber 2, but also to maintain the chamber 2 in a depressurized state (for example, the chamber 2 is in a vacuum environment).

A similar configuration of the chamber 2 mentioned above is disclosed in the patent documents 1 to 6, and the configuration may be applied as appropriate. For example, the chamber 2 may further be provided with a control unit that can adjust the supply flow rate, supply flow ratio, supply time and the like of unsaturated hydrocarbon gas and ozone gas by the unsaturated hydrocarbon gas supply part 3 and ozone gas supply part 4, and a gas supply part that supplies gases other than the unsaturated hydrocarbon gas and ozone gas (raw gas supply part 7 and inert gas supply part 8 in FIG. 6 below). In addition, it is also possible to integrate the above-mentioned unsaturated hydrocarbon gas supply part 3 and ozone gas supply part 4 (for example, in FIG. 6 below, the raw material gas supply part 7 and inert gas supply part 8 are further integrated) to form a shower head, so as to supply unsaturated hydrocarbon gas and ozone gas into the chamber 2 through the shower head.

### <One example of support configuration for joining substrate 1>

In the hydroxyl group formation step S1, lamination step S2 and joining step S3 (hereinafter collectively referred to as steps S1-S3 simply) shown in FIG. 2, although a joining substrate1 is supported as appropriate, such support configuration is not limited. For example, the chamber 2A shown in FIG. 4 can be configured to support a plurality of joining substrates 1, and with this, the hydroxyl group formation step S1 can be performed simultaneously to each of the joining substrates 1.

In addition, as in the chamber 2B show in FIG. 5, a plurality of joining substrates 1 housed in the chamber 2B can be movably supported, or each of the joining substrates 1 can be pressurized and heated.

In the case of the chamber 2B shown in FIG. 5, it is provided with a support part 6, which is capable of supporting each of two joining substrates 1a and 1b, in the chamber 2B. The support part 6 is provided with a pair of support bases 61a and 61b, which support the two joining substrates 1a and 1b respectively and are arranged facing each other, a pair of support arms 62a and 62b, which support the outer peripheries of the respective support bases 61a and 61b respectively such that the support bases 61a and 61b can move freely in contact with and apart from each other in the direction of the facing (hereinafter simply referred to as facing direction as appropriate), and a rotation shaft 63, which rotatably supports the support arms 62a and 62b along the facing direction.

The support part 6 configured in this way can rotate the support arms 62a and 62b around the rotation shaft 63 by, for example, an operation part (not shown) outside the chamber 2B to move the support bases 61a and 61b so as to be in contact with and apart from each other in the facing direction. In addition, the support bases 61a and 61b are each equipped with a heating part (not shown) which is capable of heating each of the joining substrates 1a and 1b supported by the support bases 61a and 61b.

According to this chamber 2B, the steps S1-S3 can be performed as appropriate to the joining substrates 1a and 1b. First, when performing the hydroxyl group formation step S1, as shown in FIG. 5, two joining substrates 1a and 1b are supported on the support bases 61a and 61b such that joining surfaces 10, which are one end surfaces of the respective joining substrates 1a and 1b, are positioned apart from each other in a posture of facing each other. Then, in the supported state, unsaturated hydrocarbon gas and ozone gas are supplied from the unsaturated hydrocarbon gas supply part 3 and the ozone gas supply part 4, respectively. Consequently, a radical reaction as shown in FIG. 3 occurs near the joining surfaces 10 of the respective joining substrates 1a and 1b, and hydroxyl groups are formed on the joining surfaces 10.

After this, in the lamination step S2, the support part 6 is operated to bring the support bases 61a and 61b closer together in the facing direction, such that the joining surfaces 10 of the respective joining substrates 1a and 1b can be superimposed and laminated so as to come in pressure-contact with each other. Then, in the joining step S3, by heating the joining substrates 1a and 1b in the laminated (pressure-contact) state mentioned above in a heating part, the dehydration-condensation reaction of the hydroxyl groups occurs, and the joining substrates 1a and 1b are joined via the joining surfaces 10.

Therefore, according to the chamber 2B mentioned above, in the same chamber 2B, steps S1-S3 of the joining substrates 1a and 1b can be performed in so-called in-situ.

For example, when the hydroxyl group formation step S1 is performed by the chamber 2A, the joining substrate 1 is removed from the chamber 2A and the lamination step S2 and joining step S3 are performed, and this case, there is a possibility that a small amount of moisture may remain on the joining surface 10. On the other hand, according to the chamber 2B, the steps S1-S3 can be performed in-situ as mentioned above, and it is easier to suppress moisture from remain on the joining surface 10.

### <One example of unsaturated hydrocarbon gas and ozone gas>

Various types of unsaturated hydrocarbon gas and ozone gas are applicable, as long as they can cause the radical reaction in the hydroxyl group formation step S1 to form hydroxyl groups on the joining surface 10. Specific examples of unsaturated hydrocarbon gases are shown in Table 1 below.

**[Table 1]**

| Unsaturated hydrocarbon | Chemical formula | Chemical structure | Boiling point | Molecular weight | |
|---|---|---|---|---|---|
| Ethylene | C₂H₄ | 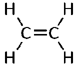 | -162.2°C | 28 | Colorless gas |
| Propylene | C₃H₆ | 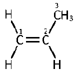 | -47.6°C | 42 | Colorless gas |
| Acetylene | C₂H₂ | H-C=C-H | -84°C | 26 | Colorless gas |
| Butadiene | C₄H₆ | 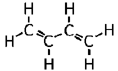 | -4.4°C | 54 | Colorless gas |
| Benzene | C₆H₆ | 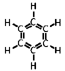 | 80.1°C | 78 | Colorless liquid |
| Toluene | C₇H₈ | 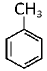 | 110.63°C | 92 | Colorless liquid |
| o-xylene | C₈H₁₀ | 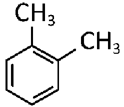 | 144°C | 106 | Colorless liquid, having isomers |
| Styrene | C₈H₈ | 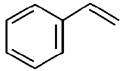 | 145°C | 104 | Colorless liquid |
| α-butylene | C₄H₈ | 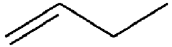 | -6.3°C | 56 | Colorless gas, having isomers |

A specific example of ozone gas is one having an ozone concentration exceeding 50 volume%, more preferably a high concentration (for example, above 90 volume% or higher).

### <One example of joining substrate 1>

The joining substrate 1 can be used as appropriate, as long as hydroxyl groups can be formed on the joining surface 10 by the hydroxyl group formation step S1 and can be directly joined through the subsequent lamination step S2 and joining step S3, and it is not particularly limited. However, if necessary, planarization treatment is performed to the joining surface 10 in advance (for example, by CMP, planarization treatment is performed such that the surface roughness is sufficiently small at the atomic level).

In addition, since the hydroxyl group formation step S1 and the joining step S3 can each be performed at relatively low temperatures, for example, when the joining substrate 1 is a substrate or film, it is not limited to substrates with relatively high heat resistance such as silicon substrates, and can be a substrate made of synthetic resin with relatively low heat resistance.

As one example, various substrates applied to MEMS, semiconductors, FPD and the like, such as silicon substrate, glass substrate, GaN substrate, SiC substrate, diamond substrate, as well as metal and film substrates, and substrates provided with a silicon oxide film (SiO₂ film) can be cited, and the same or different type substrate can be selected from among these substrates and applied.

When the joining substrate 1 is made of resin, as the resin, there can be cited, for example, polyester resin, aramid resin, olefin resin, polypropylene, PPS (polyphenylene sulfide), PET (polyethylene terephthalate) and the like.

In addition, PE (polyethylene), PEN (polyethylene naphthalate), POM (polyoxymethylene, or acetal resin), PEEK (polyetheretherketone), ABS resin (acrylonitrile, butadiene, styrene copolymer synthetic resin), PA (polyamide), PFA (4 fluorinated ethylene, perfluoroalkoxyethylene copolymer), PI (polyimide), PVD (polyvinyl dichloride), acrylic resin and the like can also be used for the joining substrate 1.

### <Verification>

Next, the joining method according to Example 1 was verified under the following verification conditions. First, a water contact angle (°) and a surface roughness Sq (Rms) of the joining surface 10 were observed in the case where the hydroxyl group formation step S1 in Example 1 was performed and the case where the hydroxyl group formation step (O₂ plasma treatment) in the conventional method was performed, applying a flat joining substrate 1 made of alkali-free glass, and the results were shown in Table 2 below. In addition, in the hydroxyl group formation step S1 of Example 1, ethylene was applied as unsaturated hydrocarbon gas.

**[Table 2]**

| | Example 1 | Conventional method | Untreated |
|---|---|---|---|
| Water contact angle (°) | 5.2 | 6.8 | 33.7 |
| Surface roughness Sq (Rms) | 0.22 | 0.56 | 0.21 |

According to Table 2, although in the case of the hydroxyl group formation step in the conventional method, it can be read that the water contact angle of the joining surface 10 is suppressed to be small, and hydroxyl groups are formed, the surface roughness increases. On the other hand, in the case of the hydroxyl group formation step S1 in Example 1, not only is the water contact angle suppressed to a small value and are hydroxyl groups formed, but also the surface roughness is suppressed to be sufficiently small.

Therefore, according to the above Example 1, in the hydroxyl group formation step S1, a sufficient amount of hydroxyl groups can be formed on the joining surface 10 of the joining substrate 1 while suppressing moisture from remaining on the joining surface 10, and in the joining step S3, the dehydration-condensation reaction of the hydroxyl groups can easily occur. In addition, since steam plasma treatment as in the conventional method is not required, the surface roughness of the joining surface 10 can be maintained in a sufficiently small state, and the subsequent lamination step S2 and joining step S3 can be easily performed as desired. Accordingly, each joining substrate 1 can be joined on joining surfaces 10 as desired.

### <<Example 2>>

For example, in the surface treatment technology as shown in the patent documents 1 and 2, the optimum value of unsaturated hydrocarbon gas : ozone gas, which is the supply flow rate ratio of unsaturated hydrocarbon gas (for example, ethylene) to ozone gas (for example, ozone gas with an ozone gas concentration of 90 volume% or higher), is considered to be approximately 1:3. The optimum value of the supply flow rate ratio of approximately 1:3 (hereinafter simply referred to as a general optimum value) is the molar ratio (1:2) for a complete oxidation reaction of ethylene and ozone molecules, and a ratio that can be empirically conditioned by focusing on the fact that the supply flow rate ratio is equivalent to the molar ratio and by conducting oxidation reaction experiments as appropriate.

Therefore, in the present Example 2, an appropriate supply flow rate ratio for the hydroxyl group formation step S1 and the water contact angle of the joining surface10 were studied.

First, the radical reaction in the hydroxyl group formation step S1 is a reaction that generates OH radicals in the process of multi-step reaction of unsaturated hydrocarbon gas with ozone gas, as described above. With this, if the ratio of ozone gas is set to be larger than the general optimum value in the multi-stage reaction, the radical reaction itself can be maintained, but the generation of OH radicals can be suppressed according to the amount of the larger ratio. As a result, it can be considered that the amount of hydroxyl groups formed on the joining surface 10 is also suppressed.

However, as compared to the case of the hydroxyl group formation step in the conventional method, it was found that even in the hydroxyl group formation step S1 in which the generation of OH radicals was suppressed as described above, a sufficient amount of hydroxyl groups was formed on the joining surface 10. In addition, it was found that the generation of moisture was also suppressed when the generation of OH radicals was suppressed as described above, although moisture could be generated in the radical reaction.

Therefore, it is preferable that in the radical reaction of the hydroxyl group formation step S1, the amount of hydroxyl groups formed on the joining surface 10 is appropriately set such that the amount of hydroxyl groups formed on the joining surface 10 does not become too much more than necessary to suppress the generation of moisture.

### <Verification>

Next, the joining method according to the present Example 2 was verified under the following verification conditions. First, silicon substrates having silicon oxide films (SiO₂ films) were applied as substrates 1a and 1b to be joined, and ethylene gas was applied as unsaturated hydrocarbon gas. Then, after appropriately setting unsaturated hydrocarbon gas : ozone gas, which is the supply flow rate ratio, in the hydroxyl group formation step S1, the water contact angle (°) of surfaces 10 to be joined (silicon oxide film surfaces) was observed, and the results shown in Table 3 below were obtained. Furthermore, the joining conditions of the joining substrates 1a and 1b after performing the hydroxyl group formation step S1 were also observed when they were joined through the lamination step S2 and joining S3, and the results shown in Table 3 below were obtained.

In addition, the supply time of both the unsaturated hydrocarbon gas and ozone gas in the hydroxyl group formation step S1 was set to 1 minute. Moreover, in the joining conditions in Table 3, the symbol "⊚" indicates the case where the joining substrates 1a and 1b were joined as desired, "Δ" indicates the case where the joining substrates 1a and 1b were joined to some extent, but not as desired, and "×" indicates the case where the joining substrates 1a and 1b were not joined.

**[Table 3]**

| Supply flow rate ratio (C₂H₄ : O₃) | Water contact angle (°) | Joining condition |
|---|---|---|
| 0:1 | 22.6 | × |
| 1:3 | 2.7 | Δ |
| 1:10 | 4.8 | ⊚ |
| 1:20 | 5.2 | ⊚ |

According to Table 3, it can be read that as the ratio of ozone gas becomes larger than the general optimum value in the supply flow rate ratio, the water contact angle of the joining surfaces 10 increases, but the joining substrates 1a and 1b are joined as desired. Therefore, the water contact angle of the joining surfaces 10 was appropriately set to be within the range of 4° to 10° under the same verification condition in Table 3, and the joining conditions of the joining substrates 1a and 1b which had been joined through the steps S1-S3 were observed, and it was confirmed that the joining substrates 1a and 1b were sufficiently joined as desired.

Therefore, according to the above Example 2, in addition to the same effects obtained in Example 1, the following can be said. That is, it is found that there is a correlation between the amount of hydroxyl groups formed on the joining surfaces 10 and the water contact angle of the joining surfaces 10, and as the amount of hydroxyl groups increases, the water contact angle decreases. In addition, it is found that the water contact angle of the joining surfaces 10 can be controlled, namely, the amount of hydroxyl groups formed on the joining surfaces 10, by appropriately adjusting the supply flow rate ratio (unsaturated hydrocarbon gas/ozone gas) in the hydroxyl group formation step S1.

Then, it is found that the amount of hydroxyl groups formed on the joining surfaces 10 can be controlled such that it is not too much more than necessary, and the generation of moisture can also be suppressed, thereby joining the joining substrates 1a and 1b easier as desired.

### <<Example 3>>

In the present Example 3, the supply flow rate ratio of both the unsaturated hydrocarbon gas and ozone gas (unsaturated hydrocarbon gas/ozone gas) to the chamber 2 was kept constant in the hydroxyl group formation step S1, and the supply flow rate and supply time of both the gases were appropriately adjusted.

### <Verification>

Under the same verification condition as in Example 2 and in the hydroxyl group formation step S1, the supply flow rate ratio of unsaturated hydrocarbon gas : ozone gas was kept constant at a value where the ratio of ozone gas was larger than the generally optimum value, and the supply flow rate and supply time of unsaturated hydrocarbon gas and ozone gas were appropriately set, and then the water contact angle (°) of the joining surfaces 10 (silicon oxide film surfaces) was observed, and the same results as in Example 2 were obtained. Furthermore, the joining conditions of the joining substrates 1a and 1b after the hydroxyl group formation step S1 were also observed when they were joined through the lamination step S2 and the joining step S3, and the same results as in Example 2 were obtained.

Therefore, according to the above Example 3, in addition to the same effects as in Examples 1 and 2, the following can be said. That is, even if the supply flow rate ratio in the hydroxyl group formation step S1 is constant, by appropriately adjusting the supply flow rate and supply time of unsaturated hydrocarbon gas and ozone gas, the amount of hydroxyl groups formed on the joining surfaces 10 can be controlled so as not to become too much more than necessary, and the generation of moisture can be suppressed, and thereby the joining substrates 1a and 1b can be joined easier as desired.

### <<Example 4>>

In the present Example 4, hybrid joining through the steps S1-S3 was verified for substrates 1 to be joined which have metal wirings (electrodes) on joining surfaces 10.

For example, in the case where hybrid joining is performed through the steps S1-S3 in the joining substrates 1 in which metal wirings made of copper are provided on the joining surfaces 10, the areas where the metal wirings are provided on the joining surfaces 10 of the joining substrates 1 (hereinafter simply referred to as metal wiring areas) are considered to be joined (Cu-Cu direct joining) by the following mechanism.

That is, hydroxyl groups in the metal wiring areas of the respective joining substrates 1 are first removed by diffusion in the joining step S3, following which the metal wiring areas are joined to each other by mutual diffusion (mutual diffusion of Cu molecules). Therefore, in terms of joining the metal wiring areas of the respective joining substrates 1, it is found that hydroxyl groups can be a factor that inhibits the joining (hereinafter simply referred to as a metal joining inhibitor). In addition, if oxide films (Cu oxide films) are formed in the metal wiring areas of the respective joining substrates 1 or if moisture remains in the metal wiring areas, the oxide films and moisture can also be the metal joining inhibitor.

On the other hand, in the case of substrates 1 to be joined in which metal wirings made of gold are provided on joining surfaces 10, oxidation of the metal wirings is difficult to occur, and it is relatively suitable for the hybrid joining, and heating for the dehydration-condensation reaction in the joining step S3 may be omitted. However, if hydroxyl groups or moisture remain in the metal wiring areas of the respective joining substrates 1, the hydroxyl groups or moisture become the metal joining inhibitor.

### <Verification>

Therefore, in the joining substrates 1a and 1b in which metal wirings made of copper or gold are provided as mentioned above, when the joining condition in the case where the joining was performed through the steps S1-S3 similar to the verification conditions in Examples 2 and 3 was observed, the same results as in Examples 2 and 3 were obtained. From the results, it can be found that in the radical reaction of the hydroxyl group formation step S1, the amount of hydroxyl groups formed on the joining surfaces 10 is not too much more than necessary and the generation of moisture is suppressed.

Therefore, even if metal wirings are provided on the joining surfaces 10 of the joining substrates 1a and 1b, by hybrid-joining them through the steps S1-S3, the amount of hydroxyl groups formed on the joining surfaces 10 can be kept from becoming too much more than necessary, and the generation of moisture can also be suppressed, thereby sufficiently joining the joining substrates 1a and 1b as desired.

### <<Example 5>>

When a silicon substrate with a silicon oxide film (SiO₂ film) is applied as a substrate 1 to be joined, moisture remaining on the surface of the silicon oxide film (joining surface 10) and moisture generated by the dehydration-condensation reaction in the joining step S3 may diffuse into the silicon oxide film in the dehydration-condensation reaction, namely, easily removed from the joining surface 10, and it is expected in the field of direct joining.

For example, in the case where the joining substrate 1 on the joining surface 10 side is uneven, before performing the steps S1-S3, a silicon oxide film is formed on the joining surface 10 side by an oxide film formation step such as a CVD method in advance (formed with a film thickness greater than the unevenness), or the surface of the silicon oxide film is subjected to planarization treatment by CMP (chemical mechanical polishing) or the like if necessary, and thereby a flat joining surface 10 can be provided on the silicon oxide film.

However, even if the substrate 1 on the joining surface 10 side is flat, when a silicon oxide film is formed on the joining surface 10 side by, for example, a CVD method, the surface of the silicon oxide film after the formation may require planarization treatment.

For example, since a silicon oxide film formed by a general CVD method is formed at relatively high temperatures (for example, over 200°C), if there is a difference in the thermal expansion coefficient between the joining substrate 1 and the silicon oxide film, thermal distortion (warping) therebetween is likely to occur. In other words, if a silicon oxide film is formed on the joining substrate 1 under a high-temperature atmosphere as mentioned above and then the joining substrate 1 is moved to a room-temperature atmosphere, thermal distortion due to temperature change occurs.

Therefore, in the present Example 5, focusing on the fact that as compared with general CVD methods, in the CVD and ALD methods shown in the patent documents 5 and 6, a silicon oxide film can be formed using a radical reaction at relatively low temperatures (for example, from approximately room temperature to 100°C), and a gas supply system applicable to the hydroxyl group formation step S1 is used, a chamber 2C as shown in FIG. 6 is configured.

The chamber 2C shown in FIG. 6 has the similar configuration to the chambers 2A and 2B, with a difference that a raw material gas supply part 7 is equipped to enable the supply of raw material gas into the chamber 2C for forming a silicon oxide film. The chamber 2C may also be equipped, in addition to the raw material gas supply part 7, with an inert gas supply part 8 that supplies inert gas into the chamber 2C as shown in FIG. 6, a support part 6 as shown in FIG. 5, and a heating part that can heat a joining substrate 1 supported by the support part 6.

Various kinds of raw material gases can be used, as long as they contain Si, which is an element that forms silicon oxide films, as a constituent element. As an example, one or more kinds selected from the organic gas source group consisting of TEOS (TetraEthyl OrthoSilicate), HMDS-O (hexamethyldisiloxane) and HMDS-N (hexamethyldisilazane) can be applied.

The inert gas can be any gas that can be applied, for example, to purge the gas in the chamber 2, and one example thereof, inert gases such as N₂, Ar, He and the like can be cited.

According to such a chamber 2C, similarly to those of the patent documents 5 and 6, by the oxide film formation step of the CVD or ALD method using the radical reaction of both unsaturated hydrocarbon gas and ozone gas, unsaturated hydrocarbon gas, ozone gas, and raw material gas are appropriately supplied to one end side surface (joining surface 10 side) of the joining substrate 1 housed in the chamber 2C, and a silicon oxide film (not shown in the drawing) can be provided on the one end side surface. Then, by appropriately supplying unsaturated hydrocarbon gas and ozone gas to the surface of the silicon oxide film (joining surface 10) of the joining substrate 1, which is housed in the chamber 2C, in the hydroxyl group formation step S1, hydroxyl groups can be formed on the surface.

When the chamber 2C is equipped with the support part 6 and the heating part as mentioned above, not only can the oxide film formation step and hydroxyl group formation step S1 be performed on one end side surface (joining surface 10 side) of each of two joining substrates 1a and 1b, but also the lamination step S2 and the joining step S3 can be performed.

Therefore, according to the chamber 2C as mentioned above, the oxide film formation step and steps S1-S3 for the joining substrates 1a and 1b can be performed in-situ in the same chamber 2C, and thermal distortion of the joining substrates 1 can be suppressed.

### <Verification>

First, silicon substrates were housed as joining substrates 1a and 1b in the chamber 2C equipped with the support part 6 and the heating part, and by performing an oxide film formation step using the CVD or ALD method using the radical reaction of both unsaturated hydrocarbon gas and ozone gas as mentioned above, an oxide film was formed on the joining surface 10 side of each of the joining substrates 1a and 1b. Then, when the joining conditions of the joining substrates 1a and 1b formed with the silicon oxide films were observed in the case of being joined through the same steps S1-S3 as in the verification conditions of Examples 2 and 3, the same results as in Examples 2 and 3 were obtained, and no influence caused by thermal distortion of the joining substrates 1a and 1b was observed.

Therefore, according to Example 5 as mentioned above, in addition to achieving the same effects as in Examples 2-4, the following can be said. That is, since the oxide film formation step and steps S1-S3 of the joining substrates 1 can be performed in-situ, it is found that the joining substrates 1a and 1b can be joined as desired and efficiently.

As the above, although, in the present embodiment, only the specific examples mentioned above have been explained in detail, it is obvious to a person skilled in the art that various changes are possible within the scope of the technical concept of the present invention, and it is natural that such changes fall within the scope of the claims. For example, the joining methods shown in Examples 1-5 may be applied separately or in appropriate combinations with each other.

In addition, the metal wirings provided on the joining substrates 1a and 1b are not limited to those made of copper or gold, but also include those made of material selected from the group of various metals such as tungsten and aluminum.

## Claims

1. (Amended) A substrate joining method comprising:
a hydroxyl group formation step for forming hydroxyl groups on surfaces to be joined of respective two substrates to be joined which are housed in a chamber;
a lamination step for superimposing the joining substrates formed with the hydroxyl groups via the joining surfaces of the respective joining substrates so as to be laminated; and
a joining step for joining the joining substrates via the joining surfaces of the respective joining substrates by heating each of the laminated joining substrates,
wherein, in the hydroxyl group formation step, the hydroxyl groups are formed on the joining surfaces by supplying unsaturated hydrocarbon gas and ozone gas with an ozone concentration exceeding 50 volume% to the joining surfaces of the joining substrates housed in the chamber to expose the joining surfaces to OH radicals generated by a radical reaction of both the unsaturated hydrocarbon gas and the ozone gas, and
wherein, in the joining step, the hydroxyl groups are subjected to a dehydration-condensation reaction by the heating.

2. The substrate joining method according to claim 1, wherein the chamber is provided with an unsaturated hydrocarbon gas supply part which supplies the unsaturated hydrocarbon gas into the chamber, an ozone gas supply part which supplies the ozone gas into the chamber, and a gas discharge part which sucks gas from the chamber and discharges it to an outside of the chamber, and
wherein the hydroxyl group formation step is performed in a state in which pressure inside the chamber is reduced.

3. The substrate joining method according to claim 1 or 2, wherein a water contact angle of the joining surfaces of the joining substrates is set within a range of 4° to 10° by the hydroxyl group formation step.

4. The substrate joining method according to claim 3, wherein the hydroxyl group formation step is performed to control an amount of the hydroxyl groups on the joining surfaces of the joining substrates by adjusting a supply flow rate ratio of both the unsaturated hydrocarbon gas and the ozone gas supplied into the chamber.

5. The substrate joining method according to claim 3, wherein the hydroxyl group formation step is performed to control an amount of the hydroxyl groups on the joining surfaces of the joining substrates by adjusting a supply flow rate and supply time of both the unsaturated hydrocarbon gas and the ozone gas such that a supply flow rate ratio of both the unsaturated hydrocarbon gas and the ozone gas supplied into the chamber is constant.

6. The substrate joining method according to claim 1 or 2, wherein metal wirings made of one of copper, gold, tungsten and aluminum are provided on the respective joining surfaces of the joining substrates, and
wherein the metal wirings provided on the respective joining substrates are joined to each other in the joining step.

7. The substrate joining method according to claim 1 or 2, wherein the chamber is provided with a support part which supports each of the joining substrates in the inside of the chamber, and
wherein the support part supports each of the joining substrates such that the joining surfaces of the respective joining substrates move freely in contact with or apart from each other in a facing direction in a posture in which the joining surfaces of the respective joining substrates face each other.

8. The substrate joining method according to claim 1 or 2, wherein each of the joining surfaces of the joining substrates is a surface of a silicon oxide film which is provided on one end side surface of each of the joining substrates in advance in an oxide film formation step, which is a step before the hydroxyl group formation step.

9. The substrate joining method according to claim 8, wherein a water contact angle of the joining surfaces of the joining substrates is set within a range of 4° to 10° by the hydroxyl group formation step.

10. The substrate joining method according to claim 8, wherein the chamber is further provided with a raw material gas supply part which supplies a raw material gas containing Si, which is an element that forms the silicon oxide film, as a constituent element, into the chamber, and
wherein the oxide film formation step is performed to form the silicon oxide film by supplying the unsaturated hydrocarbon gas, the ozone gas and the raw material gas to the one end side surface of each of the joining substrates housed in the chamber, by a chemical vapor deposition or atomic layer deposition method using a radical reaction of both the unsaturated hydrocarbon gas and the ozone gas.

11. The substrate joining method according to claim 10, wherein the chamber is provided with a support part which supports each of the joining substrates in the inside of the chamber, and
wherein the support part supports each of the joining substrates such that the joining surfaces of the respective joining substrates move freely in contact with or apart from each other in a facing direction in a posture in which the joining surfaces of the respective joining substrates face each other.

12. The substrate joining method according to claim 1 or 2, wherein the unsaturated hydrocarbon gas is one of propylene, acetylene, butadiene, benzene, toluene, o-xylene, styrene, α-butylene, 1,3-butadiene, 1,2-butadiene, 3-methyl-1,2-butadiene, 2-methyl-1,3-butadiene, 1,3-pentadiene and 2,3-dimethyl-1,3-butadiene.

13. The substrate joining method according to claim 1 or 2, wherein each of the joining substrates is a same or different type substrate selected from a group consisting of a silicon substrate, a glass substrate, a GaN substrate, a SiC substrate, a diamond substrate, a substrate formed with a silicon oxide film on one end side surface of each of the joining substrates, a metal substrate, and a film substrate.

14. The substrate joining method according to claim 10 or 11, wherein the raw material gas comprises one or more kinds selected from an organic gas source group consisting of TEOS, HMDS-O and HMDS-N.

## Amended claims

### Amended claims under Art. 19.1 PCT

1. (Amended) A substrate joining method comprising:
a hydroxyl group formation step for forming hydroxyl groups on surfaces to be joined of respective two substrates to be joined which are housed in a chamber;
a lamination step for superimposing the joining substrates formed with the hydroxyl groups via the joining surfaces of the respective joining substrates so as to be laminated; and
a joining step for joining the joining substrates via the joining surfaces of the respective joining substrates by heating each of the laminated joining substrates,
wherein, in the hydroxyl group formation step, the hydroxyl groups are formed on the joining surfaces by supplying unsaturated hydrocarbon gas and ozone gas with an ozone concentration exceeding 50 volume% to the joining surfaces of the joining substrates housed in the chamber to expose the joining surfaces to OH radicals generated by a radical reaction of both the unsaturated hydrocarbon gas and the ozone gas, and a water contact angle of the joining surfaces of the joining substrates is set within a range of 4° to 10°, and
wherein, in the joining step, the hydroxyl groups are subjected to a dehydration-condensation reaction by the heating.

2. The substrate joining method according to claim 1, wherein the chamber is provided with an unsaturated hydrocarbon gas supply part which supplies the unsaturated hydrocarbon gas into the chamber, an ozone gas supply part which supplies the ozone gas into the chamber, and a gas discharge part which sucks gas from the chamber and discharges it to an outside of the chamber, and
wherein the hydroxyl group formation step is performed in a state in which pressure inside the chamber is reduced.

3. (Cancelled)

4. (Amended) The substrate joining method according to claim 1 or 2, wherein the hydroxyl group formation step is performed to control an amount of the hydroxyl groups on the joining surfaces of the joining substrates by adjusting a supply flow rate ratio of both the unsaturated hydrocarbon gas and the ozone gas supplied into the chamber.

5. (Amended) The substrate joining method according to claim 1 or 2, wherein the hydroxyl group formation step is performed to control an amount of the hydroxyl groups on the joining surfaces of the joining substrates by adjusting a supply flow rate and supply time of both the unsaturated hydrocarbon gas and the ozone gas such that a supply flow rate ratio of both the unsaturated hydrocarbon gas and the ozone gas supplied into the chamber is constant.

6. The substrate joining method according to claim 1 or 2, wherein metal wirings made of one of copper, gold, tungsten and aluminum are provided on the respective joining surfaces of the joining substrates, and
wherein the metal wirings provided on the respective joining substrates are joined to each other in the joining step.

7. The substrate joining method according to claim 1 or 2, wherein the chamber is provided with a support part which supports each of the joining substrates in the inside of the chamber, and
wherein the support part supports each of the joining substrates such that the joining surfaces of the respective joining substrates move freely in contact with or apart from each other in a facing direction in a posture in which the joining surfaces of the respective joining substrates face each other.

8. The substrate joining method according to claim 1 or 2, wherein each of the joining surfaces of the joining substrates is a surface of a silicon oxide film which is provided on one end side surface of each of the joining substrates in advance in an oxide film formation step, which is a step before the hydroxyl group formation step.

9. (Cancelled)

10. The substrate joining method according to claim 8, wherein the chamber is further provided with a raw material gas supply part which supplies a raw material gas containing Si, which is an element that forms the silicon oxide film, as a constituent element, into the chamber, and
wherein the oxide film formation step is performed to form the silicon oxide film by supplying the unsaturated hydrocarbon gas, the ozone gas and the raw material gas to the one end side surface of each of the joining substrates housed in the chamber, by a chemical vapor deposition or atomic layer deposition method using a radical reaction of both the unsaturated hydrocarbon gas and the ozone gas.

11. The substrate joining method according to claim 10, wherein the chamber is provided with a support part which supports each of the joining substrates in the inside of the chamber, and
wherein the support part supports each of the joining substrates such that the joining surfaces of the respective joining substrates move freely in contact with or apart from each other in a facing direction in a posture in which the joining surfaces of the respective joining substrates face each other.

12. The substrate joining method according to claim 1 or 2, wherein the unsaturated hydrocarbon gas is one of propylene, acetylene, butadiene, benzene, toluene, o-xylene, styrene, α-butylene, 1,3-butadiene, 1,2-butadiene, 3-methyl-1,2-butadiene, 2-methyl-1,3-butadiene, 1,3-pentadiene and 2,3-dimethyl-1,3-butadiene.

13. The substrate joining method according to claim 1 or 2, wherein each of the joining substrates is a same or different type substrate selected from a group consisting of a silicon substrate, a glass substrate, a GaN substrate, a SiC substrate, a diamond substrate, a substrate formed with a silicon oxide film on one end side surface of each of the joining substrates, a metal substrate, and a film substrate.

14. (Amended) The substrate joining method according to claim 10, wherein the raw material gas comprises one or more kinds selected from an organic gas source group consisting of TEOS, HMDS-O and HMDS-N.
